# EUROPEAN PATENT SPECIFICATION

(11) **EP 2 945 471 B1**
(45) Date of publication and mention of the grant of the patent: **19.07.2017**
(21) Application number: 15161467.4
(22) Date of filing: 27.03.2015
(51) Int. Cl.: H05K 7/14

(54) **INTEGRATED POWER CONVERTING APPARATUS FOR VEHICLE**
INTEGRIERTE ENERGIEUMWANDLUNGSVORRICHTUNG FÜR EIN FAHRZEUG
APPAREIL DE CONVERSION D'ÉNERGIE INTÉGRÉ POUR VÉHICULE

(30) Priority: 24.04.2014 KR 20140049083
(43) Date of publication of application: 18.11.2015
(73) Proprietor: Hyundai Motor Company, Seoul 137-938 (KR); Kia Motors Corporation, Seoul 137-938 (KR)
(72) Inventor: Yoon, Jae Hoon, 120-050 Seoul (KR); Shin, Dong Min, 448-130 Gyeonggi-do (KR); Jeon, Woo Yong, 137-761 Seoul (KR); Joo, Jung Hong, 440-710 Gyeonggi-do (KR)
(74) Representative: Isarpatent

(56) References cited:
- EP-A2- 2 023 473
- CN-Y- 201 227 959
- DE-A1-102011 089 076
- DE-A1-102012 008 873
- US-A1- 2011 261 588

## Description

### BACKGROUND

### Technical Field

The present invention relates to an integrated power converting apparatus for a vehicle, and more particularly, to a power converting apparatus for a vehicle, which reinforces the rigidity of a housing and promote performance optimization and improves assembly efficiency.

### Discussion of the Related Art

An environmentally friendly vehicle using a motor as a driving source, such as an electric vehicle or hybrid vehicle generally uses a fuel cell high voltage battery or the like as an energy source for driving the motor. The environmentally friendly vehicle uses, as power conversion components, an inverter for providing power to the motor and a low direct current to direct current (DC-DC) converter (LDC) configured to generate 12V power for a vehicle. Conventionally, a package of a structure including the inverter and the LDC was frequently applied as an integrated power converting apparatus for a vehicle.

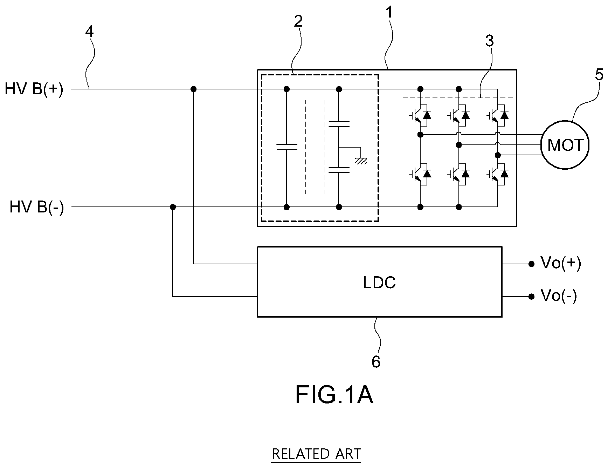

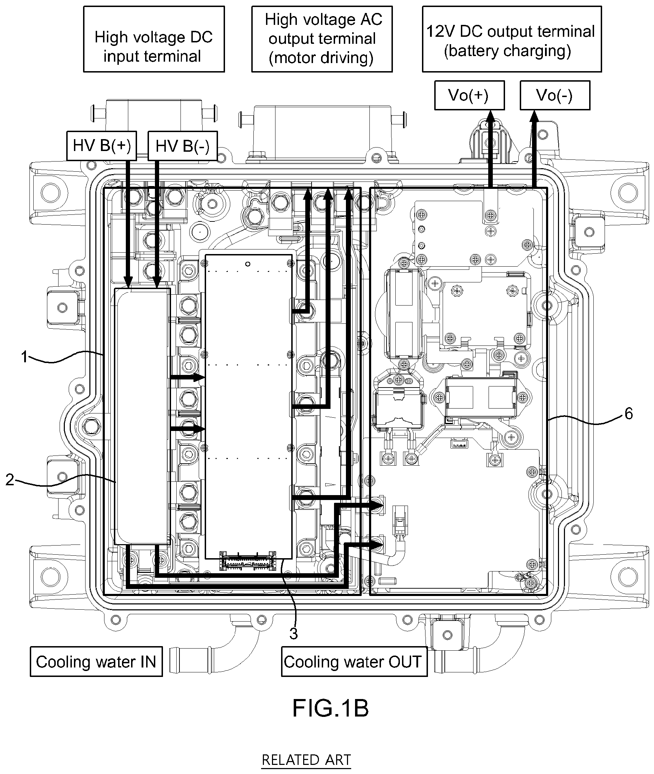

Referring to FIGS. 1A and 1B, in a conventional integrated power converting apparatus including an inverter and an LDC, a high voltage DC input through a high voltage DC input terminal 4 is converted into alternating current (AC) using a capacitor module 2, allowing a motor 5 to be driven by the converted AC output from the inverter 1. The high voltage DC input through the high voltage DC input terminal 4 is converted into low voltage using several elements within the LDC 6, so that the LDC 6 outputs 12V.

However, in the conventional integrated power converting apparatus configured as described above, an integrated control board (not shown) for operating the inverter and the LDC is mounted together with the inverter and the LDC in a housing, and therefore, electromagnetic waves (e.g., electromagnetic fields) of the integrated control board have influence on the inverter and the LDC. Accordingly, the performance of the conventional integrated power converting apparatus may be deteriorated.

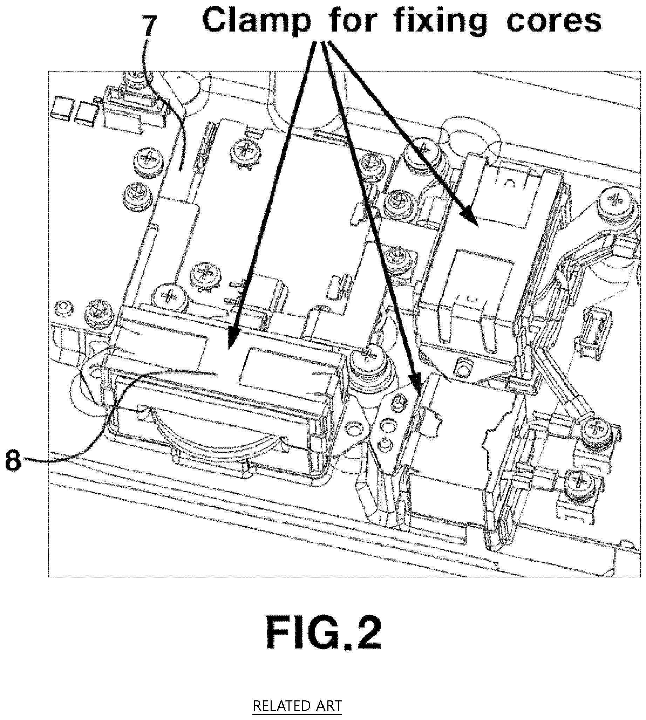

As shown in FIG. 2, in the conventional integrated power converting apparatus, a clamp 8 is mounted on a bottom surface of a housing 7 to fix cores (e.g., transformers, ZVCs, chalk coils and inductors) constituting the LDC. In particular, a fastening structure for fixing the clamp 8 should be provided to the bottom surface of the housing 7, and therefore, the area of the bottom surface of the housing is increased.

Document US 2011 / 0 261 588 A1 discloses an inverter module and an integrated-inverter electric compressor. Document DE 10 2012 008 873 A1 discloses a method for air-cooling power electronics.

### SUMMARY

The present invention provides an integrated power converting apparatus with the features of claim 1, configured by integrating an inverter configured to drive a motor and a converter configured to output a low voltage, wherein the inverter and the converter may be disposed on an inner bottom surface of a housing. A shield plate may be mounted at a predetermined height from the inner bottom surface of the housing, and an integrated control board configured to operate the inverter and the converter may be disposed on a top surface of the shield plate. A first space portion may be formed between the integrated control board and the housing, and signal wires for signal connection between the integrated control board and the inverter and between the integrated control board and the converter may be disposed in the first space portion.

The shield plate may be disposed above the converter, and a clamp for fixing cores, disposed within the converter, may be mounted on a bottom surface of the shield plate. The inverter may be configured to include a power module and a capacitor module, and the capacitor module may be disposed below the shield plate or disposed in a second space portion formed between the housing and the shield plate. A cover for opening and closing the housing may be disposed at the top end of the housing.

As described above, the integrated power converting apparatus according to the present invention may have advantages as follows.

First, since the plate-shape shield plate may be disposed inside the housing of a box structure, the power converting components (the inverter and the converter) and the integrated control board may be structurally separated, so that it may be possible to reduce or minimize influence of electromagnetic waves of the integrated control board, which have influence on the power converting components, thereby improving performance.

Second, since the plate-shape shield plate may be disposed inside the housing of the box structure, it may be possible to ensure structural rigidity.

Third, the first space portion may be formed between the housing and the integrated control board, and the signal wires for signal connection may be disposed between the power converting components and the integrated control board, so that it may be possible to simplify layout and to improve assembly efficiency.

Fourth, the layout of the signal wires may be simplified, and the clamp for fixing cores of the converter (LDC) may be mounted on a bottom surface of the shied plate, so that it may be possible to decrease the area of the bottom surface of the housing for component mounting.

### BRIEF DESCRIPTION OF THE DRAWINGS

The above and other objects, features and other advantages of the present invention will be more clearly understood from the following detailed description when taken in conjunction with the accompanying drawings, in which:
FIGS. 1A and 1B are exemplary views schematically illustrating a conventional integrated power converting apparatus according to the related art;
FIG. 2 is an exemplary view illustrating problems of the conventional integrated power converting apparatus shown in FIGS. 1A and 1B according to the related art;
FIG. 3 illustrates exemplary views of an integrated power converting apparatus according to an exemplary embodiment of the present invention;
FIG. 4 is an exemplary view illustrating a clamp for fixing cores, which is fastened to a bottom surface of a shield plate in the integrated power converting apparatus according to an exemplary embodiment of the present invention;
FIG. 5 illustrates exemplary views of an integrated power converting apparatus according to an exemplary embodiment of the present invention; and
FIG. 6 illustrates exemplary views of an integrated power converting apparatus according to an exemplary embodiment of the present invention.

It should be understood that the appended drawings are not necessarily to scale, presenting a somewhat simplified representation of various features illustrative of the basic principles of the invention. The specific design features of the present invention as disclosed herein, including, for example, specific dimensions, orientations, locations, and shapes will be determined in part by the particular intended application and use environment. In the figures, reference numbers refer to the same or equivalent parts of the present invention throughout the several figures of the drawing.

### DETAILED DESCRIPTION

It is understood that the term "vehicle" or "vehicular" or other similar term as used herein is inclusive of motor vehicles in general such as passenger automobiles including sports utility vehicles (SUV), buses, trucks, various commercial vehicles, watercraft including a variety of boats and ships, aircraft, and the like, and includes hybrid vehicles, electric vehicles, plug-in hybrid electric vehicles, hydrogen-powered vehicles and other alternative fuel vehicles (e.g. fuels derived from resources other than petroleum). As referred to herein, a hybrid vehicle is a vehicle that has two or more sources of power, for example both gasoline-powered and electric-powered vehicles.

Although exemplary embodiments are described as using a plurality of units to perform the exemplary process, it is understood that the exemplary processes may also be performed by one or plurality of modules. Additionally, it is understood that the term controller/control unit refers to a hardware device that includes a memory and a processor. The memory is configured to store the modules and the processor is specifically configured to execute said modules to perform one or more processes which are described further below.

Furthermore, control logic of the present invention may be embodied as non-transitory computer readable media on a computer readable medium containing executable program instructions executed by a processor, controller/control unit or the like. Examples of the computer readable mediums include, but are not limited to, ROM, RAM, compact disc (CD)-ROMs, magnetic tapes, floppy disks, flash drives, smart cards and optical data storage devices. The computer readable recording medium can also be distributed in network coupled computer systems so that the computer readable media is stored and executed in a distributed fashion, e.g., by a telematics server or a Controller Area Network (CAN).

The terminology used herein is for the purpose of describing particular exemplary embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

Unless specifically stated or obvious from context, as used herein, the term "about" is understood as within a range of normal tolerance in the art, for example within 2 standard deviations of the mean. "About" can be understood as within 10%, 9%, 8%, 7%, 6%, 5%, 4%, 3%, 2%, 1%, 0.5%, 0.1%, 0.05%, or 0.01% of the stated value. Unless otherwise clear from the context, all numerical values provided herein are modified by the term "about."

Hereinafter reference will now be made in detail to various exemplary embodiments of the present invention, examples of which are illustrated in the accompanying drawings and described below. While the invention will be described in conjunction with exemplary embodiments, it will be understood that present description is not intended to limit the invention to those exemplary embodiments. On the contrary, the invention is intended to cover not only the exemplary embodiments, but also various alternatives, modifications, equivalents and other exemplary embodiments, which may be included within the spirit and scope of the invention as defined by the appended claims.

The present invention provides an integrated power converting apparatus configured into a package structure including an inverter configured to drive a motor and a converter configured to output a low voltage. It should be understood that "a low voltage" is intended mean a voltage of about 12V or below. The integrated power converting apparatus may have a structure which may structurally reinforce the rigidity of a housing and promote performance optimization and improve assembly efficiency. In general, a low voltage would be about 60V or less but based on vehicle performance in the present invention, low voltage is about 12V or less and high voltage is about 240-413V.

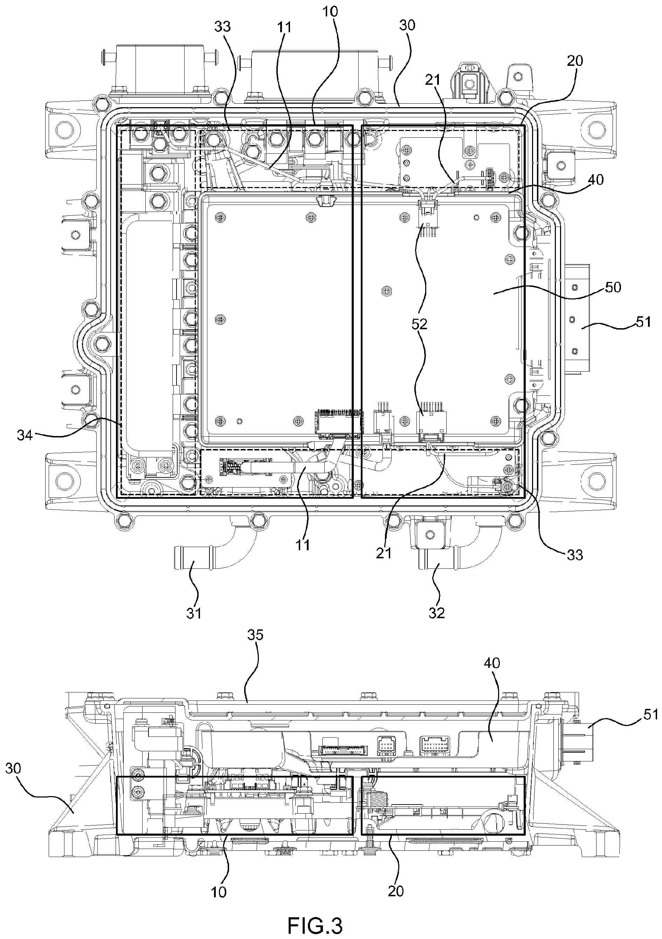

An integrated power converting apparatus may include an inverter configured to drive a motor and a converter configured to output a low voltage. As shown in FIG. 3, an inverter 10 and a converter 20 may be disposed on an inner bottom surface of a housing 30. The housing 30 may be formed in a box shape having a predetermined depth, and a cooling water inlet 31 and a cooling water outlet 32 may be formed at one side of the housing 30. Although not shown in this figure, a flow path for the flow of cooling water circulated through the cooling water inlet 31 and the cooling water outlet 32 may be formed in the inner bottom surface of the housing 30. The inverter 10 and the converter 20 may be cooled by the cooling water circulated through the flow path.

As is known in the art, the inverter is a power converting component configured to drive a motor. The inverter may be configured to include a capacitor module configured to receive a DC high voltage input from a high voltage input terminal, and a power module configured to receive an input from the capacitor module to convert the received output into an AC voltage. It should be understood that high voltage is intended to mean a voltage exceeding about _V. In addition, as known in the art, the converter (LDC) is a power converting component for low voltage output, which is configured to convert a DC high voltage input from a high voltage input terminal into a DC low voltage. The converter generally converts a high voltage of a battery into a low voltage (e.g., about 12V) for a vehicle. A shield plate 40 for shielding electromagnetic waves may be mounted at a predetermined height from the inner bottom surface of the housing 30.

As shown in FIG. 3, the shield plate 40 may be formed in a plate shape having a predetermined thickness or a shape having a groove structure (e.g., a groove structure that holds and mounts an integrated control board) with a predetermined depth. The shield plate 40 may be disposed at a substantially middle height of the housing 30. An integrated control board 50 configured to integrate and operate the inverter 10 and the converter 20 may be disposed on a top surface of the shield plate 40. In particular, the integrated control board 50 and the shield plate 40 may have a size smaller than the sectional area of the housing 30. Thus, first and second space portions 33 and 34 having a predetermined distance may be formed between the integrated control board 50 and the housing 40.

As illustrated in FIG. 3, the first space portions 33 may be formed at both front and rear sides of the integrated control board 50 and between sidewall surfaces of the housing 30, respectively, and the second space portion 34 may be formed between a left side of the integrated control board 50 and a sidewall surface of the housing 30. A connection terminal 51 for an input from the exterior and/or an output from the exterior may be disposed at a right side of the integrated control board 50, although other locations for the connection terminal 51 are within the scope of the invention. The connection terminal 51 may protrude outward from the housing 30 to allow for connection to the exterior.

A plurality of signal wires 11 and 21 configured to allow wired control signal transmission between the integrated control board 50 and the inverter 10 and between the integrated control board 50 and the converter 20 may be disposed in the first space portion 33. One or more connectors 52 connected to the signal wires 11 and 21 may be disposed at both the front and rear sides of the integrated control board 50. In other words the signal wires 11 and 21 of the inverter 10 and the converter 20 may be disposed in the first space portion 33, and configured to be connected to the connector 52 of the integrated control board 50. The integrated control board 50 may transmit control signals to the inverter 10 and the converter 20, disposed below the shield plate 40 via the signal wires 11 and 21.

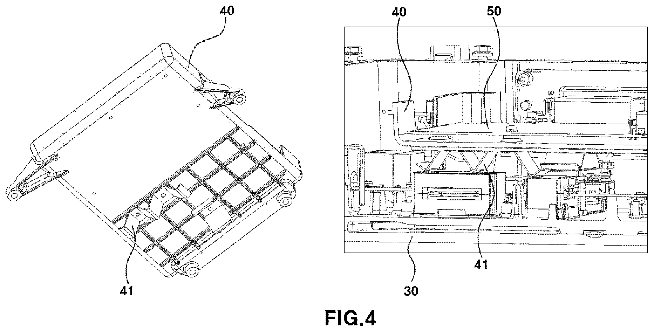

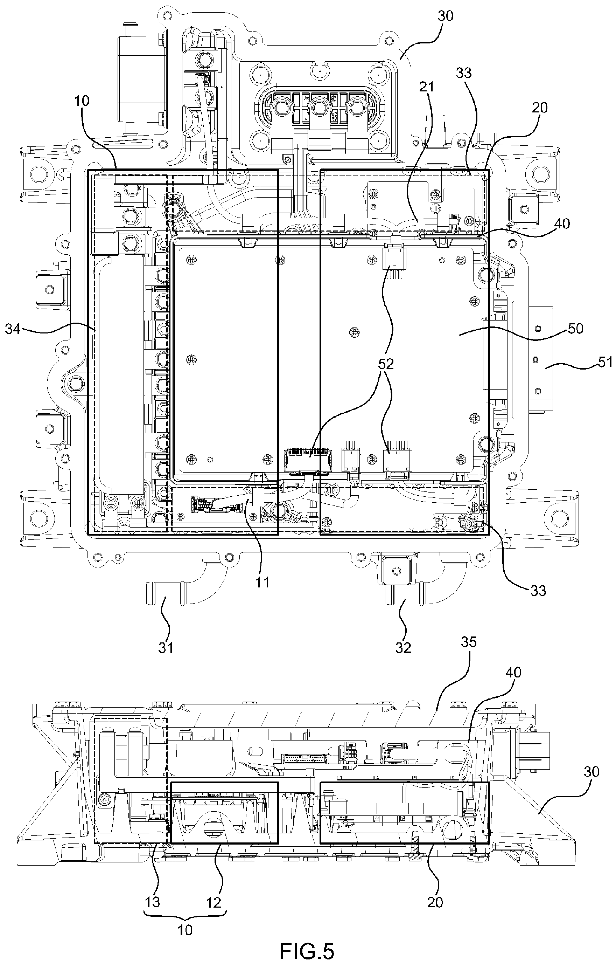

As shown in FIG. 4, a clamp 41 configured to fix cores (e.g., transformers, ZVCs, chalk coils, inductors and the like) disposed in the converter 20 may be fastened and disposed on the bottom surface of the shield plate 40. The clamp 41 may support cores disposed at a predetermined position in the converter 20 when the shield plate 40 is disposed within the housing 30 to be disposed above the converter 20. When the clamp 41 is mounted on the bottom surface of the shield plate 40, it may be unnecessary to provide a fastener to mount the clamp 41 on the bottom surface of the housing 30. Thus, the area of the bottom surface of the housing 30 for mounting the clamp 41 may be decreased compared to the conventional art, to improve output density. Meanwhile, as shown in another exemplary embodiment of FIG. 5, the converter 20 and the power module 12 of the inverter 10 may be disposed below the shield plate 40, and the capacitor module 13 of the inverter 10 may be disposed in the second space portion 34 formed between the housing 30 and the shield plate 40.

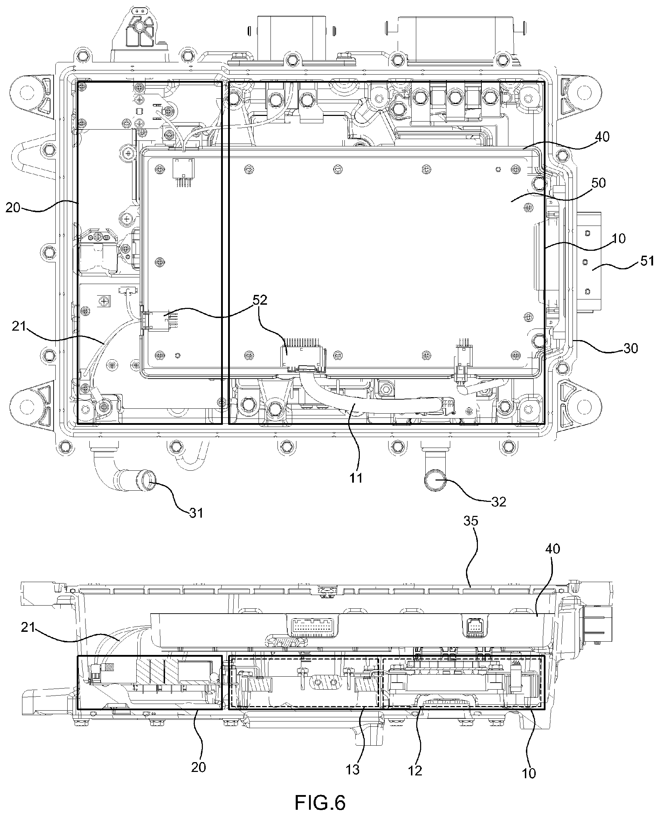

Specifically, the capacitor module 13 may be disposed on the inner bottom surface of the housing 30. In particular, the capacitor module 13 may be disposed on the inner bottom surface of the housing 30 at a lower portion of the second space portion 34. The capacitor module 13 may be formed up to the height of the shield plate 40 (or a lower portion of a cover to be described later) from the inner bottom surface of the housing 30. Thus, the capacitor module 13 may be positioned in the second space portion 34. As illustrated in FIG. 6, the capacitor module 13 of the inverter 10 may be disposed below the shield plate 40, between the power module 12 at the left side thereof and the converter 20 at the right side thereof (it should be noted that other positionings of such structures are within the scope of the invention and that "left" and "right" are used merely for the sake of explanation). The shape of the housing 30 may be modified within the technical scope of the present invention, and a cover 35 which may be opened or closed may cover the top end of the housing 30 and may be disposed at the top end of the housing 30.

The invention has been described in detail with reference to exemplary embodiments thereof. However, it will be appreciated by those skilled in the art that changes may be made in these exemplary embodiments without departing from the principles and spirit of the invention, the scope of which is defined in the appended claims and their equivalents.

## Claims

1. An integrated power converting apparatus for an electric vehicle, comprising:
a housing (30),
an inverter (10) configured to drive a motor and configured to include a capacitor module (13) configured to receive a DC high voltage input from a high voltage input terminal, and a power module (12) configured to receive an input from the capacitor module (13) to convert the received output into an AC voltage,
a DC-DC converter (20) configured to output a low voltage,
an integrated control board (50) being configured to operate the inverter (10) and an electromagnetic shield plate (40),
**characterized in that:**
the inverter (10) and the converter (20) are disposed on an inner bottom surface of a housing (30), the shield plate (40) has a predetermined thickness and is disposed on the inverter (10) and the converter (20) at a predetermined height from the inner bottom surface of the housing (30) reinforcing its rigidity; and
the integrated control board (50) is disposed on a top surface of the shield plate (40).

2. The integrated power converting apparatus of claim 1, wherein a first space portion is formed between the integrated control board (50) and the housing (30), and signal wires configured to allow signal transmission between the integrated control board (50) and the inverter (10) and between the integrated control board (50) and the converter (20) are disposed in the first space portion.

3. The integrated power converting apparatus of claim 1, further comprising:
a clamp configured to fix cores disposed within the converter (20) and mounted on a bottom surface of the shield plate (40),
wherein the shield plate (40) is disposed above the converter (20), and the clamp.

4. The integrated power converting apparatus of claim 1, wherein the inverter (10) includes a power module (12) and a capacitor module (13), and the capacitor module (13) is disposed below the shield plate (40).

5. The integrated power converting apparatus of claim 1, wherein the inverter (10) includes a power module (12) and a capacitor module (13), and the capacitor module (13) is positioned in a second space portion formed between the housing (30) and the shield plate (40).

6. The integrated power converting apparatus of claim 1, further comprising:
a cover configured to be opened or closed, wherein the cover is disposed at a top end of the housing (30).

## Patentansprüche

1. Integrierte Leistungswandlervorrichtung für ein Elektrofahrzeug, umfassend:
ein Außengehäuse (30),
einen Inverter (10), der dafür ausgebildet ist, einen Motor anzutreiben, und dafür ausgebildet ist, ein Kondensatormodul (13) zu umfassen, das dafür ausgebildet ist, eine Eingangsgleichstrom-Hochspannung von einem Hochspannungseingangsanschluss zu empfangen, sowie ein Leistungsmodul (12) zu umfassen, das dafür ausgebildet ist, ein Eingangssignal von dem Kondensatormodul (13) zu empfangen, um das empfangene Ausgangssignal in eine Wechselspannung umzuwandeln,
einen Gleichstrom-Gleichstrom-Wandler (20), der dafür ausgebildet ist, eine Niederspannung auszugeben,
eine integrierte Steuerplatine (50), die dafür ausgebildet ist, den Inverter (10) und eine elektromagnetische Abschirmplatte (40) zu betreiben,
**dadurch gekennzeichnet, dass**:
der Inverter (10) und der Wandler (20) auf einer inneren Bodenfläche eines Gehäuses (30) angeordnet sind, die Abschirmplatte (40) eine zuvor festgelegte Dicke hat und auf dem Inverter (10) und dem Wandler (20) in einer zuvor festgelegten Höhe von der inneren Bodenfläche des Gehäuses (30) angeordnet ist und seine Steifigkeit erhöht; und
die integrierte Steuerplatine (50) auf einer Oberseite der Abschirmplatte (40) angeordnet ist.

2. Integrierte Leistungswandlervorrichtung nach Anspruch 1, wobei ein erster Raumabschnitt zwischen der integrierten Steuerplatine (50) und dem Gehäuse (30) ausgebildet ist, und Signaldrähte, die dafür ausgebildet sind, eine Signalübertragung zwischen der integrierten Steuerplatine (50) und dem Inverter (10) und zwischen der integrierten Steuerplatine (50) und dem Wandler (20) zu ermöglichen, in dem ersten Raumabschnitt angeordnet sind.

3. Integrierte Leistungswandlervorrichtung nach Anspruch 1, des Weiteren umfassend:
eine Klemme, die dafür ausgebildet ist, Kerne zu befestigen, die innerhalb des Wandlers (20) angeordnet und auf einer Bodenfläche der Abschirmplatte (40) montiert sind,
wobei die Abschirmplatte (40) über dem Wandler (20) und der Klemme angeordnet ist.

4. Integrierte Leistungswandlervorrichtung nach Anspruch 1, wobei der Inverter (10) ein Leistungsmodul (12) und ein Kondensatormodul (13) umfasst und das Kondensatormodul (13) unter der Abschirmplatte (40) angeordnet ist.

5. Integrierte Leistungswandlervorrichtung nach Anspruch 1, wobei der Inverter (10) ein Leistungsmodul (12) und ein Kondensatormodul (13) umfasst und das Kondensatormodul (13) in einem zweiten Raumabschnitt positioniert ist, der zwischen dem Gehäuse (30) und der Abschirmplatte (40) ausgebildet ist.

6. Integrierte Leistungswandlervorrichtung nach Anspruch 1, die des Weiteren eine Abdeckung umfasst, die dafür ausgebildet ist, geöffnet oder geschlossen zu werden, wobei die Abdeckung an einem oberen Ende des Gehäuses (30) angeordnet ist.

## Revendications

1. Appareil de conversion de puissance intégré pour un véhicule électrique, comprenant :
un boîtier (30),
un onduleur (10) configuré pour entraîner un moteur et configuré pour inclure un module de condensateur (13) configuré pour recevoir une entrée haute tension CC à partir d'une borne d'entrée haute tension, et un module de puissance (12) configuré pour recevoir une entrée du module de condensateur (13) pour convertir la sortie reçue en une tension alternative,
un convertisseur c.c.-c.c. (20) configuré pour délivrer une basse tension,
une carte de commande intégrée (50), qui est configurée pour faire fonctionner l'onduleur (10) et une plaque de blindage électromagnétique (40),
**caractérisé en ce que** :
l'onduleur (10) et le convertisseur (20) sont disposés sur une surface inférieure intérieure d'un boîtier (30), la plaque de blindage (40) a une épaisseur prédéterminée et est disposée sur l'onduleur (10) et le convertisseur (20) à une hauteur prédéterminée par rapport à la surface inférieure intérieure du boîtier (30), renforçant sa rigidité ; et
la carte de commande intégrée (50) est disposée sur une surface supérieure de la plaque de blindage (40).

2. Appareil de conversion de puissance intégré selon la revendication 1, dans lequel une première partie d'espace est formée entre la carte de commande intégrée (50) et le boîtier (30), et des fils de signaux, configurés pour permettre une transmission de signaux entre la carte de commande intégrée (50) et l'onduleur (10) et entre la carte de commande intégrée (50) et le convertisseur (20), sont disposés dans la première partie d'espace.

3. Appareil de conversion de puissance intégré selon la revendication 1, comprenant en outre :
une bride configurée pour fixer des coeurs disposés dans le convertisseur (20) et montés sur une surface inférieure de la plaque de blindage (40),
dans lequel la plaque de blindage (40) est disposée au-dessus du convertisseur (20) et de la bride.

4. Appareil de conversion de puissance intégré selon la revendication 1, dans lequel l'onduleur (10) comprend un module de puissance (12) et un module de condensateur (13), et le module de condensateur (13) est disposé au-dessous de la plaque de blindage (40).

5. Appareil de conversion de puissance intégré selon la revendication 1, dans lequel l'onduleur (10) comprend un module de puissance (12) et un module de condensateur (13), et le module de condensateur (13) est positionné dans une seconde partie d'espace formée entre le boîtier (30) et la plaque de blindage (40).

6. Appareil de conversion de puissance intégré selon la revendication 1, comprenant en outre :
un couvercle configuré pour être ouvert ou fermé, dans lequel le couvercle est disposé au niveau d'une extrémité supérieure du boîtier (30).
